# EUROPEAN PATENT APPLICATION

(11) **EP 2 469 588 A2**
(43) Date of publication of application: **27.06.2012**
(21) Application number: 11194723.0
(22) Date of filing: 21.12.2011
(51) Int. Cl.: H01L 21/687

(54) **Susceptor for CVD Apparatus, CVD Apparatus and Substrate Heating Method using the Same**

(30) Priority: 23.12.2010 KR 20100133341
(71) Applicant: Samsung LED Co., Ltd., Yongi-City, Gyeonggi-Do (KR)
(72) Inventor: Rhee, Do Young, Seoul (KR); Lim, Jin Young, Gyeonggi-do (KR); Han, Sang Heon, Gyeonggi-do (KR); Kim, Ki Sung, Gyeonggi-do (KR); Kim, Young Sun, Gyeonggi-do (KR); Kim, Sung Tae, Seoul (KR)
(74) Representative: Grünecker, Kinkeldey, Stockmair & Schwanhäusser

(57) **Abstract**

Provided are a susceptor for a chemical vapor deposition (CVD) apparatus, including: a susceptor body having an upper surface opposed to a lower surface thereof and formed of a light transmitting material, the upper surface thereof having at least one pocket part formed to receive a substrate therein; and a light absorbing unit formed of a light absorbing material on the upper surface of the susceptor body.

## Description

### CROSS-REFERENCE TO RELATED APPLICATIONS

This application claims the priority of Korean Patent Application No. 10-2010-0133341 filed on December 23, 2010, in the Korean Intellectual Property Office, the disclosure of which is incorporated herein by reference.

### BACKGROUND OF THE INVENTION

### Field of the Invention

The present invention relates to a susceptor and a chemical vapor deposition (CVD) apparatus, and more particularly, to a susceptor for a CVD apparatus, and a CVD apparatus including the same, allowing for the uniform heating of a semiconductor growth substrate.

### Description of the Related Art

Recently, a metal organic chemical vapor deposition (MOCVD) has come to prominence as one of various chemical vapor deposition (CVD) technologies according to developments in micro-LEDs and highly efficient LED outputs.

MOCVD is one of various CVD vapor phase growth methods for a compound semiconductor in which a metal compound is deposited on a semiconductor substrate through a thermal decomposition reaction in an organic metal and in which a reactive gas passes over a heated wafer generating a chemical vapor deposition of a reactive material thin film, and therefore, a number of layers may be formed on the wafer through consecutive processes.

At this time it is necessary to form a thin film having a uniform thickness across the entire surface of a wafer. Therefore, the controlling of the temperature in the heating of the wafer to have a uniformly heat throughout may be more important.

### SUMMARY OF INVENTION

An aspect of the present invention provides a susceptor and a chemical vapor deposition (CVD) apparatus capable of uniformly heating a substrate even in the case of a bowing effect occurring in the substrate when heating the substrate mounted on the susceptor so as to grow a high quality semiconductor thereon.

According to an aspect of the present invention, there is provided a susceptor for a CVD apparatus including: a susceptor body having an upper surface opposed to a lower surface thereof and formed of a light transmitting material, the upper surface thereof having at least one pocket part formed to receive a substrate therein; and a light absorbing unit formed of a light absorbing material on the upper surface of the susceptor body.

The pocket part may include a bottom portion and a step part formed at a position spaced apart from the bottom portion in an upward direction, on which a rim of the substrate may be supported.

The step part may be formed in the susceptor body or at an end part of the light absorbing unit that is formed to extend to the pocket part.

The light transmitting material may be at least one selected from a group consisting of quartz, sapphire and a translucent ceramic.

The light absorbing material may be at least one selected from a group consisting of graphite, SiC and graphite coated with SiC.

The light absorbing material may absorb light of 400nm to 100µm in wavelength.

According to another aspect of the present invention, there is provided a CVD apparatus including: a chamber; a susceptor for a CVD apparatus adapted within the chamber, and including a susceptor body having an upper surface opposed to a lower surface thereof and formed of a light transmitting material, the upper surface thereof having at least one pocket part formed to receive a substrate therein, and a light absorbing unit formed of a light absorbing material on the upper surface of the susceptor body; and a heating lamp emitting light to heat the lower surface of the susceptor.

The pocket part may include a bottom portion and a step part formed at a position spaced apart from the bottom portion in an upward direction, on which a rim of the substrate may be supported.

The substrate may be provided to have the light absorbing layer bondedly combined therewith or to be formed separately thereto.

The pocket part may include a step part in which the substrate is supported, and a bottom, and the bottom of the pocket part may be spaced apart from the step part by a given interval.

The step part may be formed in the susceptor body or at an end part of the light absorbing unit that is formed to extend to the pocket part.

The light absorbing material may absorb light of 400nm to 100µm in wavelength.

The light transmitting material may be at least one selected from a group consisting of quartz, sapphire and a translucent ceramic.

The light absorbing material may be at least one selected from a group consisting of graphite, SiC and graphite coated with SiC.

Further comprising a light absorbing layer formed of the light absorbing material on the lower surface of the substrate, and wherein the light absorbing layer may be formed by laminating a plurality of layers of materials having different coefficients of thermal expansion.

According to another aspect of the present invention, there is provided a method of heating a substrate by using a CVD apparatus including: arranging a susceptor for a CVD apparatus including a susceptor body having an upper surface opposed to a lower surface thereof and formed of a light transmitting material, and a light absorbing unit formed of a light absorbing material on the upper surface of the susceptor body, the upper surface having at least one pocket part formed to receive the substrate therein; forming a light absorbing layer formed of a light absorbing material on a lower surface of the sbustrate formed of a light transmitting material; mouting the substrate having the light abosorbing layer formed on the lower surface thereof, in the pocket part, and disposing the mounted substrate within a chamber of the CVD apparatus; and irradiating light to the lower surface of the susceptor body to provide heat thereto.

The substrate may be formed of at least one selected from a group consisting of quartz, sapphire and a translucent ceramic.

The substrate may be provided with the light absorbing layer deposited on or bonded to the lower surface thereof.

The light absorbing layer may be formed by laminating a plurality of layers of materials having different coefficients of thermal expansion.

According to another aspect of the present invention, there is provided a method of heating a substrate by using a CVD apparatus including: arranging a susceptor for a CVD apparatus including a susceptor body having an upper surface opposed to a lower surface thereof and formed of a light transmitting material, and a light absorbing unit formed of a light absorbing material on the upper surface of the susceptor body, the upper surface having at least one pocket part formed to receive the substrate therein; forming a light absorbing layer in the pocket; mounting the substrate on the light absorbing layer and disposing the mounted substrate within a chamber of the CVD apparatus; and irradiating light to the lower surface of the susceptor body to provide heat thereto.

The light absorbing layer may be formed by laminating a plurality of layers of materials having different coefficients of thermal expansion.

### BRIEF DESCRIPTION OF DRAWINGS

The above and other aspects, features and other advantages of the present invention will be more clearly understood from the following detailed description taken in conjunction with the accompanying drawings, in which:

FIG. 1 is a configuration diagram of a susceptor according to the related art;

FIG. 2 illustrates a figure in which a substrate mounted on a susceptor is heated according to the related art;

FIG. 3 shows a susceptor for a CVD apparatus according to an embodiment of the present invention;

FIG. 4 shows a susceptor for a CVD apparatus and a substrate according to another embodiment of the present invention;

FIG. 5 shows a susceptor for a CVD apparatus and a substrate according to another embodiment of the present invention;

FIG. 6 is a conceptual diagram of a CVD apparatus according to another embodiment of the present invention; and

FIG. 7 is a flowchart illustrating a method of heating a substrate using a CVD apparatus according to another embodiment of the present invention.

### DETAILED DESCRIPTION OF PREFERRED EMBODIMENT

Exemplary embodiments of the present invention will now be described in detail with reference to the accompanying drawings such that they could be easily practiced by those having skill in the art to which the present invention pertains. However, in describing the exemplary embodiments of the present invention, detailed descriptions of well-known functions or constructions will be omitted so as not to obscure the description of the present invention with unnecessary detail.

In addition, like reference numerals denote like elements throughout the drawings.

Unless explicitly described to the contrary, the word "comprise" and variations such as "comprises" or "comprising," will be understood to imply the inclusion of stated elements but not the exclusion of any other elements.

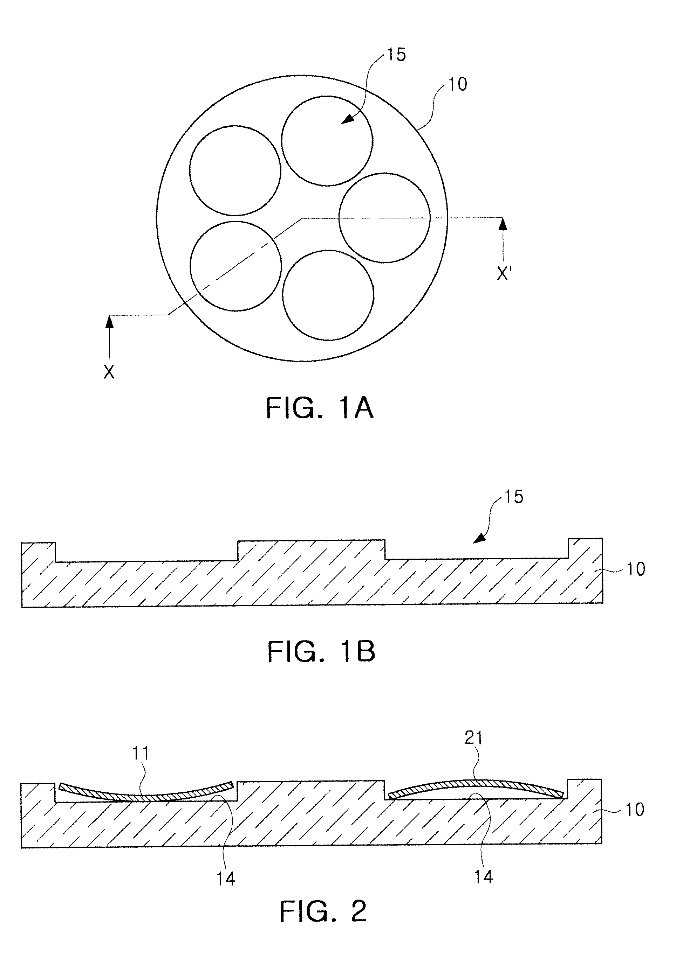

FIG. 1 is a configuration diagram of a susceptor according to the related art. Referring to FIG. 1A, a susceptor 10 may include a plurality of pocket parts 15 formed to be recessed by a preset depth, in which substrates to be processed are supported. FIG. 1B is a cross-sectional view of the susceptor 10 taken along line X-X' shown in FIG. 1A.

FIG. 2 illustrates an instance in which a susceptor receiving a substrate mounted thereon is heated according to the related art. With reference to FIG. 2, when heat is applied to substrates 11 and 12, the substrates may be bowed.

The substrate 11 in the left pocket part of the susceptor 10 is shown as being convex towards the susceptor 10. That is, a center of the substrate 11 may be in contact with a bottom 14 of the pocket part, and a rim of the substrate 11 may be separated from the bottom 14 of the pocket part, such that the temperature of the center of the substrate 11 may be higher than that of the rim of the substrate 11 to thereby cause an uneven substrate temperature.

The substrate 21 in the right pocket part of the susceptor 10 may be upwardly convex. In this case, a rim of the substrate 21 may be in contact with the bottom 14 of the pocket part and a center of the substrate 21 may be separated from the bottom of the pocket part, such that the temperature of the rim of the substrate 21 may be higher than that of the center of the substrate 21 to cause an uneven substrate temperature.

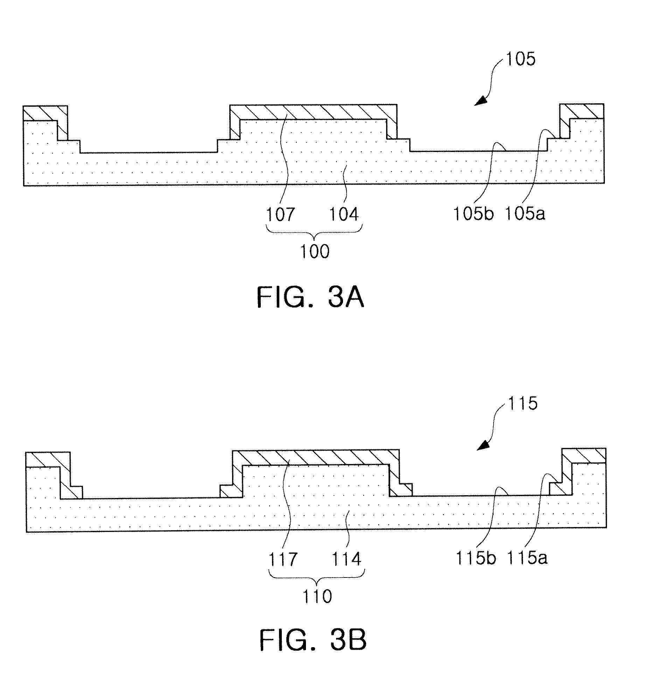

FIG. 3 shows a susceptor for a CVD apparatus according to an embodiment of the present invention. With reference to FIG. 3A, the susceptor for the CVD apparatus 100 may include a susceptor body 104 and a light absorbing unit 107.

The susceptor body 104 may be formed of a light transmitting material and have at least one pocket part 105. The light transmitting material may be formed of at least one selected from a group of quartz, sapphire and a translucent ceramic.

The pocket part 105 may include a step part 105a on which the rim of the substrate is supported, and a bottom 105b. The step part 105a may be formed at a position spaced apart from the bottom 105b in an upward direction, on which a rim of the substrate is supported. Though described in detail below, the step part 105a may be formed at a position spaced apart from the bottom 105b in an upward direction such that, when a heated substrate is curved to be convex toward the susceptor, a space to receive the substrate is provided so as to prevent the curved substrate from being in contact with the bottom 105b.

The light absorbing unit 107 may be formed on an upper surface of the susceptor body 104 and formed of a light absorbing material so as to absorb light having passed through the susceptor body 104. The light absorbing material may be at least one selected from a group consisting of graphite, SiC and graphite coated with SiC. The light absorbing material may absorb light of 400nm to 100µm in wavelength.

Referring to FIG. 3B, in a susceptor 110 for a CVD apparatus according to another embodiment of the present invention, a step part 115a may be formed at an end part of a light absorbing unit 117 that is formed to extend to a pocket part 115. Herein, constructions such as a susceptor body 114, the pocket part 115 and a bottom 115b of the pocket part, and the like have the same as or similar to those in FIG. 3A, thus the detailed description therefor will be omitted below.

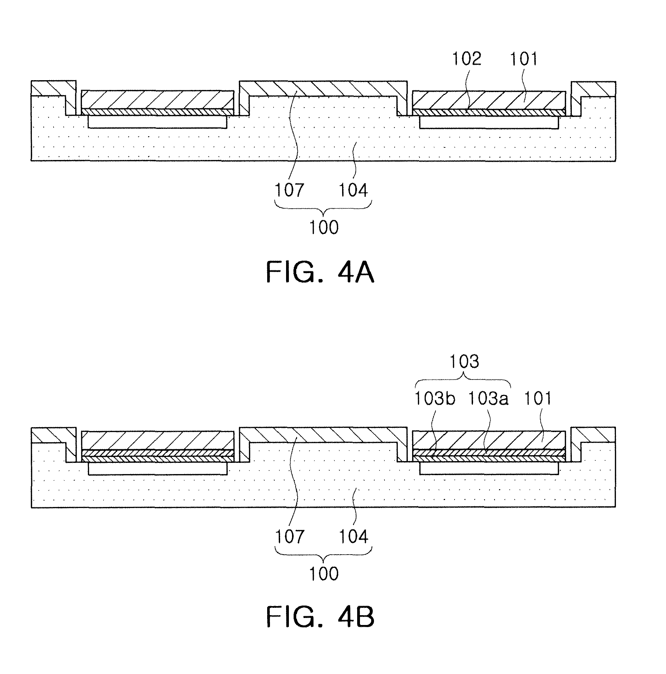

FIG. 4 shows a susceptor for a CVD apparatus and a substrate according to another embodiment of the present invention. With reference to FIG. 4A, a susceptor 100 may include a substrate 101 and a first light absorbing layer 102 that is formed on a lower surface of the substrate 101 and formed of a light absorbing material.

The substrate 101 may be provided to be separated from the first light absorbing layer 102, or provided with the first light absorbing layer 102 deposited on the lower surface thereof or provided with the first light absorbing layer 102 bonded thereto.

The substrate 101 may be formed of at least one selected from a group consisting of quartz, sapphire and a translucent ceramic. The substrate 101 may be provided with a semiconductor structure stacked thereon.

The first light absorbing layer 102 may be formed of a light absorbing material to absorb light passed through the susceptor body of the susceptor and transfer heat to the substrate 101. The light absorbing material may be at least one selected from a group consisting of graphite, SiC and graphite coated with SiC. The coefficient of thermal expansion of the first light absorbing layer 102 may be approximate to a coefficient of thermal expansion of the substrate 101, such that the first light absorbing layer 102 may be closely bonded to the substrate 101 to uniformly transfer heat to the substrate 101, even when a bowing effect occurs in the substrate 101.

With reference to FIG. 4B, the susceptor 100 may include the substrate 101 and a second light absorbing layer 103 that is formed of a light absorbing material in a lower part of the substrate 101. The second light absorbing layer 103 may be formed to include laminated material layers 103a and 103b with different coefficients of thermal expansion. The second light absorbing layer 103 may be configured to be approximate to a coefficient of thermal expansion of the substrate 101 by being composed of materials having different coefficients of thermal expansion. The substrate may be provided to have the light absorbing layer bondedly combined therewith or to be formed separately thereto. In order to uniformly transfer heat to the substrate 101, the substrate 101 and the second light absorbing layer 103 may be adapted to be combined with each other.

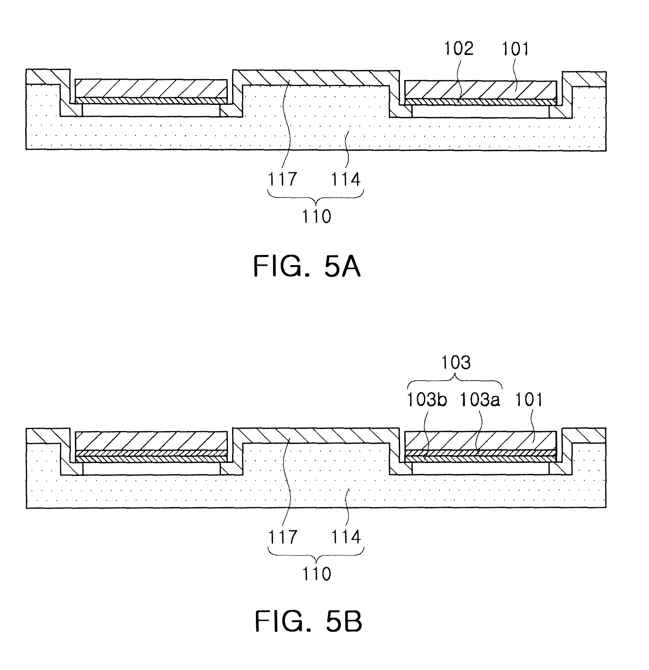

FIG. 5 shows a susceptor for a CVD apparatus and a substrate according to another embodiment of the present invention. FIGS. 5A and 5B show embodiments in which the substrate is mounted on the susceptor 110 shown in FIG. 3B. FIGS. 5A and 5B are similar to FIGS. 4A and 4B in the configuration thereof, and thus, a detailed description thereof will be omitted.

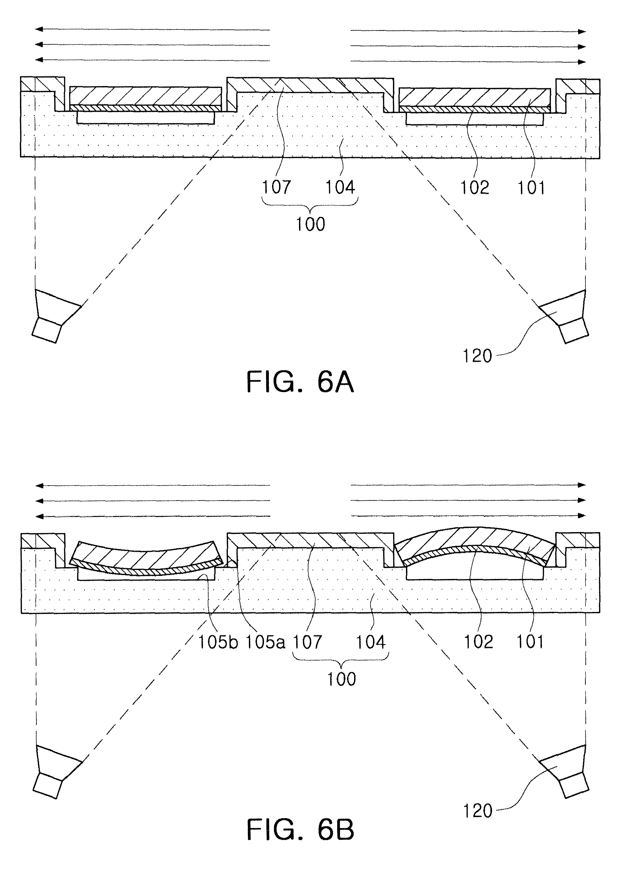

FIG. 6 is a conceptual diagram of a CVD apparatus according to another embodiment of the present invention. FIG. 6A illustrates a CVD apparatus provided before the substrate 101 and the susceptor 104 are sufficiently heated. The CVD apparatus may include the chamber (not shown), the susceptor 104 and a heating lamp 120. The chamber may have a space to receive the substrate 101 and the susceptor 100.

Since the substrate 101 is not yet substantially heated so as not to have the bowing effect evident, the substrate 101 may maintain an approximately planar shape. Source gas as a raw material of a semiconductor to be deposited on the substrate 101 may flow in an upper part of the substrate 101 and susceptor 100.

The heating lamp 120 may irradiate light to the lower surface of the susceptor 100 to transfer heat to the light absorbing unit 107 through the susceptor body 104. A wavelength of light emitted from the heating lamp 120 may be, for example, approximately 400nm to 100µm, that is, approximately 700nm to 100µm as the wavelength of rays within the infrared region.

With reference to FIG. 6B, the susceptor 100 and the substrate are sufficiently heated to generate the bowing effect in the substrate. The substrate in the left pocket part of the susceptor 100 is shown to be curved convexly toward to the first light absorbing layer 102. The step part 105a may be formed at a position spaced apart from the bottom 105b of the pocket part in an upward direction so as to have a space able to receive the curved substrate 101.

The substrate 101 in the right pocket part of the susceptor 100 in FIG. 6B is shown to be convexly curved in a direction opposite to that of the first light absorbing layer 102. According to the embodiment of the present invention, since the substrate 101 may be closely bonded to the first light absorbing layer 102 regardless of the convexly curved direction of the substrate 101 toward the first light absorbing layer 102 or in its opposite direction, heat may be uniformly supplied to the substrate 101 on which a semiconductor layer is formed, such that the substrate maintains uniform temperature to form a semiconductor layer having enhanced quality.

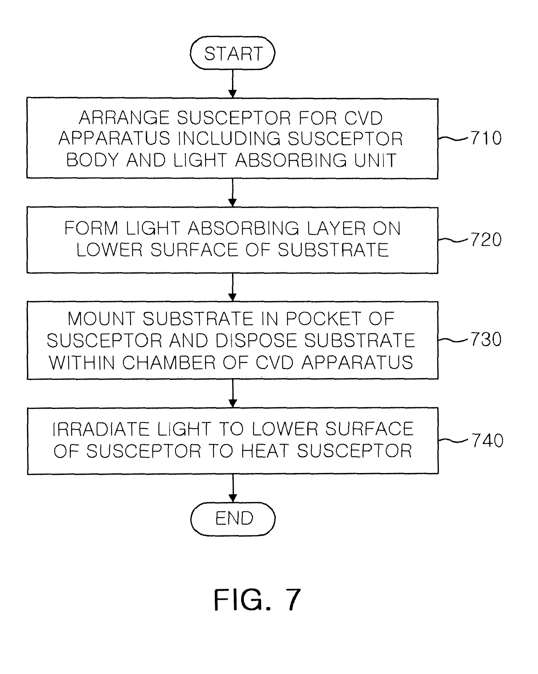

FIG. 7 is a flowchart illustrating a method of heating a substrate using a CVD apparatus according to another embodiment of the present invention.

Referring to FIG. 7, a susceptor for a CVD apparatus including a susceptor body and a light absorbing unit may be arranged in operation 710. In the susceptor for the CVD apparatus, the light absorbing unit may be formed by covering or depositing a light absorbing material on an upper surface of the susceptor body that is formed of a light transmitting material, or the susceptor may be arranged by bonding the light absorbing unit to the upper surface of the susceptor body.

A light absorbing layer formed of the light absorbing material may be formed on a lower surface of the substrate that is formed of a light transmitting material, in operation 720. As an example, the light absorbing layer may be formed to be deposited on the lower surface of the substrate or to be bonded to the lower surface of the substrate.

The substrate having the light absorbing layer formed thereunder may be mounted in the pocket part and disposed in the chamber of the CVD apparatus in operation 730. That is, the substrate may be mounted in the pocket part such that the light absorbing layer may be supported on the step part of the pocket part.

Instead of forming the light absorbing layer on the lower surface of the substrate in the operation 720, a separate light absorbing layer formed separately from the substrate may be mounted in the pocket part, and thereon, the substrate may be mounted.

Subsequently, light may be irradiated to the lower surface of the susceptor body by using the heating lamp to heat the susceptor and the substrate in operation 740.

As set forth above, according to an embodiment of the present invention, an enhanced quality of semiconductor growth on the substrate may be obtained by uniformly heating the substrate even when a bowing effect occurs on the substrate in heating the substrate.

While the present invention has been shown and described in connection with the exemplary embodiments, it will be apparent to those skilled in the art that modifications and variations can be made without departing from the spirit and scope of the invention as defined by the appended claims.

## Claims

1. A susceptor for a chemical vapor deposition (CVD) apparatus, comprising:
a susceptor body having an upper surface opposed to a lower surface thereof and formed of a light transmitting material, the upper surface thereof having at least one pocket part formed to receive a substrate therein; and
a light absorbing unit formed of a light absorbing material on the upper surface of the susceptor body.

2. The susceptor of claim 1, wherein the pocket part includes a bottom portion and a step part formed at a position spaced apart from the bottom portion in an upward direction, on which a rim of the substrate is supported.

3. The susceptor of claim 1, wherein the light transmitting material is at least one selected from a group consisting of quartz, sapphire and a translucent ceramic.

4. The susceptor of claim 1, wherein the light absorbing material is at least one selected from a group consisting of graphite, SiC and graphite coated with SiC.

5. The susceptor of claim 1, wherein the light absorbing material absorbs light of 400nm to 100µm in wavelength.

6. A CVD apparatus comprising:
a chamber;
a susceptor for a CVD apparatus adapted within the chamber, and including a susceptor body having an upper surface opposed to a lower surface thereof and formed of a light transmitting material, the upper surface thereof having at least one pocket part formed to receive a substrate therein, and a light absorbing unit formed of a light absorbing material on the upper surface of the susceptor body; and
a heating lamp emitting light to heat the lower surface of the susceptor.

7. The apparatus of claim 6, wherein the pocket part includes a bottom portion and a step part formed at a position apart from the bottom portion in an upward direction, on which a rim of the substrate is supported.

8. The apparatus of claim 6, wherein the light absorbing material absorbs light of 400nm to 100µm in wavelength.

9. The apparatus of claim 6, wherein the light transmitting material is at least one selected from a group consisting of quartz, sapphire and a translucent ceramic.

10. The apparatus of claim 6, wherein the light absorbing material is at least one selected from a group consisting of graphite, SiC and graphite coated with SiC.

11. The apparatus of claim 6, further comprising a light absorbing layer formed of the light absorbing material on the lower surface of the substrate, and wherein the light absorbing layer is formed by laminating a plurality of layers of materials having different coefficients of thermal expansion.

12. A method of heating a substrate by using a CVD apparatus, the method comprising:
arranging a susceptor for a CVD apparatus including a susceptor body having an upper surface opposed to a lower surface thereof and formed of a light transmitting material, and a light absorbing unit formed of a light absorbing material on the upper surface of the susceptor body, the upper surface having at least one pocket part formed to receive the substrate therein;
forming a light absorbing layer formed of a light absorbing material on a lower surface of the sbustrate formed of a light transmitting material;
mouting the substrate having the light abosorbing layer formed on the lower surface thereof, in the pocket part, and disposing the mounted substrate within a chamber of the CVD apparatus; and
irradiating light to the lower surface of the susceptor body to provide heat thereto.

13. The method of claim 12, wherein the substrate is formed of at least one selected from a group consisting of quartz, sapphire and a translucent ceramic.

14. A method of heating a substrate by using a CVD apparatus, the method comprising:
arranging a susceptor for a CVD apparatus including a susceptor body having an upper surface opposed to a lower surface thereof and formed of a light transmitting material, and a light absorbing unit formed of a light absorbing material on the upper surface of the susceptor body, the upper surface having at least one pocket part formed to receive the substrate therein;
forming a light absorbing layer in the pocket;
mounting the substrate on the light absorbing layer and disposing the mounted substrate within a chamber of the CVD apparatus; and
irradiating light to the lower surface of the susceptor body to provide heat thereto.

15. The method of claims 12 or 14, wherein the light absorbing layer is formed by laminating a plurality of layers of materials having different coefficients of thermal expansion.
